Europäisches Patentamt

European Patent Office

Office européen des brevets

(11) Veröffentlichungsnummer: **0 229 247**
**A2**

## (12) EUROPÄISCHE PATENTANMELDUNG

(21) Anmeldenummer: **86115128.0**

(22) Anmeldetag: **31.10.86**

(51) Int. Cl.⁴: **H03K 17/95**

(30) Priorität: **15.01.86 DE 3600979**

(43) Veröffentlichungstag der Anmeldung:
**22.07.87 Patentblatt 87/30**

(84) Benannte Vertragsstaaten:
**AT CH DE FR GB IT LI SE**

(71) Anmelder: **Rheinmetall GmbH**
**Ulmenstrasse 125 Postfach 6609**
**D-4000 Düsseldorf(DE)**

(72) Erfinder: **Klinkhardt, Erhard**
**Helmholtzstrasse 6**
**D-4040 Neuss 1(DE)**

(74) Vertreter: **Podszus, Burghart Dipl.-Phys.**
**Rheinmetall GmbH Ulmenstrasse 125**
**Postfach 6609**
**D-4000 Düsseldorf(DE)**

(54) **Berührungsloser Signalgeber.**

(57) Bei einem berührungslosen Signalgeber zur Abgabe eines Signals bei genügender Annäherung eines zweiten Teiles an einen ersten Teil und bei einem Verfahren zum Betrieb eines derartigen Signalgebers weist der erste Teil (10) eine erste Sendeeinrichtung (14, L1) für ein Grundsignal und eine zweite Empfangseinrichtung (L4) zum Empfang eines ersten Signals auf, der zweite Teil (30) ist zum Empfang des Grundsignals mit einer ersten Empfangseinrichtung (L2) versehen, von der in Reaktion auf das Grundsignal eine Signalerzeugungseinrichtung (34, 36) zur Erzeugung des ersten Signals und eines zweiten Signals, welches dem ersten Signal aufprägbar (38) ist, beaufschlagbar ist, und der Signalerzeugungseinrichtung (34, 36) ist eine zweite Sendeeinrichtung (L3) nachgeschaltet, deren Signal von einer zweiten Empfangseinrichtung (L4) im ersten Teil (10) aufnehmbar ist.

EP 0 229 247 A2

FIG. 1

## Berührungsloser Signalgeber

Die Erfindung betrifft einen berührungslosen Signalgeber zur Abgabe eines Signals bei genügender Annäherung eines zweiten Teiles an einen ersten Teil sowie ein Verfahren zum Betrieb eines derartigen berührungslosen Signalgebers.

Derartige berührungslose Signalgeber werden insbesondere bei der automatisierten Bearbeitung von Werkstücken, zur Überwachung von Sicherungseinrichtungen (zum Beispiel Schutztüren an Maschinen), bei automatisierten Regalsteuerungen, bei der Übertragung spezifischer Daten, etwa zur Weichenstellung an Transportbändern oder fahrerlosen Transporteinrichtungen und ähnlichem, eingesetzt. Hierzu kann ein auf das permanente Magnetfeld eines Ferriten reagierender Anzeigekopf vorgesehen werden. Es hat sich jedoch gezeigt, daß hierbei Störungen auftreten oder leicht Manipulationen durchgeführt werden können, insbesondere an Schutzeinrichtungen. Einmal kann die Sicherheitsfunktion, welche eigentlich durch den Permanentmagneten oder Ferrite bereitgestellt werden soll, einfach durch einen anderen Permanentmagneten oder Ferrite übersteuert werden. Weiterhin können bestimmte Werkstoffe von dem Magnetfeld des Permanent-oder Elektromagneten durchflutet werden, so daß der Indikator das Vorliegen eines Magnetfeldes oder dessen Beeinflussung anzeigt, wodurch der Anschein erweckt wird, als sei die Arbeitsposition frei oder erreicht, obwohl sie in Wahrheit durch einen fremden Werkstoff besetzt ist.

Weiterhin reicht es in vielen Fällen nicht aus, nur eine Freigabe bezüglich der Arbeits-oder Bearbeitungsstation zu geben; zur Bearbeitung eines Werkstückes ist nämlich weiterhin erforderlich, daß erkannt werden kann, ob das Werkstück sicher in der zugehörigen Einspannvorrichtung aufgenommen, diese also fertig gespannt ist. Dies läßt sich mit den bekannten Einrichtungen nicht erreichen.

Der Erfindung liegt daher die Aufgabe zugrunde, einen berührungslosen Signalgeber bereitzustellen, bei dem mit erhöhter Sicherheit sowohl die richtige Positionierung eines zweiten Teiles als auch eine weitere Einflußgröße des zweiten Teiles, beispielsweise das Spannen dieses zweiten Teiles in einer Spannvorrichtung, festgestellt werden kann. Bezüglich des Verfahrens liegt der Erfindung die Aufgabe zugrunde, das bekannte Verfahren weiterzuentwickeln und so zu ermöglichen, daß ein berührungsloser Signalgeber nicht durch übliche Störeinflüsse beeinflußt und damit auch manipuliert werden kann.

Der Erfindung liegt die Erkenntnis zugrunde, in einem ersten (aktiven) Teil ein Signal zu erzeugen, welches im zweiten Teil bei Empfang die Erzeugung eines Signals bewirkt, welches in Abhängigkeit von einer weiteren Einflußgröße beeinflußt werden kann. Beide Signale werden dann wiederum an den ersten Teil zurückgesendet, und nur bei gleichzeitigem Vorliegen beider Signale erfolgt die Freigabe des Signalgebers.

Die Aufgabe wird bezüglich der Vorrichtung dadurch gelöst, daß der erste Teil eine erste Sendeeinrichtung für ein Grundsignal und eine zweite Empfangseinrichtung zum Empfang eines ersten Signals aufweist, daß der zweite Teil zum Empfang des Grundsignals mit einer ersten Empfangseinrichtung versehen ist, von der in Reaktion auf das Grundsignal eine Signalerzeugungseinrichtung zur Erzeugung des ersten Signales und eines zweiten Signales, welches dem ersten Signal aufprägbar ist, beaufschlagbar ist, und daß der Signalerzeugungseinrichtung eine zweite Sendeeinrichtung nachgeschaltet ist, deren Signal von der zweiten Empfangseinrichtung im ersten Teil aufnehmbar ist.

Ist daher der zweite Teil genügend nahe am ersten Teil, so wird vom zweiten Teil das Grundsignal empfangen. Die Intensität des empfangenen Signals ist hierbei ein Maß für den Abstand. Bei genügender Intensität wird in Reaktion auf das empfangene Grundsignal ein erstes Signal erzeugt, das von der zweiten Sendeeinrichtung wieder an den ersten Teil zurückgesendet und dort von der zweiten Empfangseinrichtung empfangen wird. Der Empfang dieses ersten Signals im ersten Teil des Signalgebers signalisiert, daß der zweite Teil, der sogenannte Echokopf, genügend nahe an dem ersten Teil, dem Grundgerät, ist. Dann wird ein erstes Freigabesignal im Grundgerät erzeugt. Erst wenn das dem ersten Signal aufgeprägte zweite Signal ebenfalls im Grundgerät empfangen und nachgewiesen wird, wird ein zweites Freigabesignal abgegeben. Nur bei Vorliegen des ersten und des zweiten Freigabesignals erfolgt die Freigabe.

Mit der erfindungsgemäßen Vorrichtung wird eine äußerst hohe Sicherheit erreicht. Der aus Grundgerät und Echokopf bestehende Signalgeber kann praktisch nicht unabsichtlich übersteuert und damit die Sicherheitsfunktion außer Kraft gesetzt werden. Selbst eine absichtliche Übersteuerung ist nur unter großen Schwierigkeiten möglich, da hierfür die Frequenzen des ersten beziehungsweise zweiten Signales erst ermittelt werden müssen. Demgegenüber würde es nach dem Stand der Technik ausreichen, zur Übersteuerung der Sicherheitsfunktion ein permanentmagnetisches Material bereitzuhalten. Die Erfindung ist daher vorteilhafterweise auch in Bereichen mit erhöhten Sicherheitsanforderungen einsetzbar, auch in Bereichen, die nur nach Erfüllung gewisser Zugangsbedingungen zugänglich sein dürfen.

Bei einer vorteilhaften Ausgestaltung der Erfindung ist vorgesehen, daß der zweiten Empfangseinrichtung eine Filtereinrichtung nachgeschaltet ist, die auf das erste Signal abgestimmt ist. Hierdurch wird eine erhöhte Störsicherheit erreicht, da Störungen normalerweise nicht auf das erste Signal abgestimmt sind und somit ausgefiltert werden. -

Diese Maßnahme läßt sich entsprechend auch auf das zweite Signal anwenden, und daher sieht eine vorteilhafte Ausgestaltung der Erfindung vor, daß der Filtereinrichtung weiterhin eine auf das zweite Signal abgestimmte Einrichtung nachgeschaltet ist.

Ist gemäß einer vorteilhaften weiteren Ausgestaltung der Erfindung die Filtereinrichtung ein aktives Bandpaßfilter, so erfolgt eine besonders gute Abstimmung des Filters auf das Signal.

Bei einer weiteren vorteilhaften Ausgestaltung der Erfindung ist vorgesehen, daß der Filtereinrichtung eine erste Einrichtung zur Erzeugung eines ersten Ausgangssignals in Reaktion auf das erste Signal nachgeschaltet ist. Dieses erste Ausgangssignal gibt die voranstehend erwähnte erste Freigabe. Entsprechend sieht eine weitere vorteilhafte Ausgestaltung der Erfindung vor, daß der auf das zweite Signal abgestimmten Einrichtung eine Einrichtung zur Erzeugung eines zweiten Ausgangssignals nachgeschaltet ist. Dieses zweite Ausgangssignal ist das zweite Freigabesignal.

Ist gemäß einer weiteren vorteilhaften Ausgestaltung der Erfindung die erste Sendeeinrichtung eine Induktivität mit daran gekoppeltem Oszillator und die erste Empfangseinrichtung eine Induktivität, so erfolgt die Übertragung des Grundsignals durch die Kopplung dieser beiden Induktivitäten bei Annäherung des Echokopfes an das Grundgerät. Es läßt sich hierdurch auf einfache Weise eine Anpassung an unterschiedlichste Übertragungsbedingungen bewerkstelligen. Durch geeignete Dimensionierung der Spulen und/oder durch geeignete Wahl der Oszillatorfrequenz, die bevorzugt 4,5 kHz beträgt, läßt sich der erfindungsgemäße Signalgeber an unterschiedlichste Einsatzbedingungen anpassen. In diesem Zusammenhang ist hervorzuheben, daß auch äußerlich gleich aussehende Geräte durch unterschiedliche Induktivitäten und/oder Oszillatoren bei völlig verschiedenen Werten arbeiten können. Hierdurch wird selbst eine gewollte mißbräuchliche Benutzung stark erschwert oder verhindert.

Es ist weiterhin von Vorteil, wenn die Signalerzeugungseinrichtung im zweiten Teil einen Oszillator mit einem frequenzbestimmenden Glied umfaßt. Dieses frequenzbestimmende Glied läßt sich innerhalb gewisser Grenzen einfach austauschen.

Ist gemäß einer weiteren vorteilhaften Ausgestaltung der Erfindung das frequenzbestimmende Glied ein Schwingquarz, so ist dieser Oszillator, der ja keine eigene Stromversorgung aufweist, sondern nur von dem empfangenen Grundsignal beaufschlagt wird, betriebsmäßig gegen Spannungsschwankungen und damit wechselnde Empfangsverhältnisse geschützt; jedenfalls führen derartige Spannungsschwankungen nicht zu einer Frequenzverschiebung.

Bei einer weiteren vorteilhaften Ausgestaltung der Erfindung ist vorgesehen, daß dem Oszillator ein Frequenzteiler nachgeschaltet ist. Der nachgeschaltete Frequenzteiler gibt dann nämlich ebenfalls eine stabile (heruntergeteilte) Frequenz ab. Der erzielbare Vorteil wird vergrößert und die erfindungsgemäße Vorrichtung weiter vereinfacht, wenn gemäß einer weiteren vorteilhaften Ausgestaltung von dem Frequenzteiler das erste Signal und das zweite Signal abgebbar ist. Diese beiden Signale sind daher ebenfalls sehr stabil, was die Zuverlässigkeit des zweiten Teiles vergrößert.

Bei einer weiteren vorteilhaften Ausgestaltung der Erfindung ist vorgesehen, daß das erste Signal eine Frequenz von etwa 41 kHz aufweist. Das erste Signal liegt damit beinahe eine Größenordnung oberhalb des Grundsignals, so daß eine gegenseitige Beeinflussung dieser beiden Signale praktisch nicht auftreten kann. In diesem Zusammenhang hat sich eine weitere Ausgestaltung der Erfindung als vorteilhaft erwiesen, bei welcher das zweite Signal eine Frequenz von etwa 600 bis 700 Hz, bevorzugt 640 Hz, aufweist. Auch dieses Signal ist daher genügend weit von den übrigen Signalen entfernt.

Bei einer besonders vorteilhaften Ausgestaltung der Erfindung weist der Schwingquarz eine Schwingfrequenz von 655,36 kHz auf, die von dem Frequenzteiler auf 40,96 kHz zur Erzeugung des ersten Signals beziehungsweise auf 640 Hz zur Erzeugung des zweiten Signals heruntergeteilt wird. Auf diese Weise werden hochstabile erste und zweite Signale erhalten.

Bei einer weiteren vorteilhaften Ausgestaltung der Erfindung ist zur Aufprägung des zweiten Signals auf das erste Signal ein Modulator vorgesehen. Dies macht die nachgeschalteten Sende-und Empfangseinrichtungen besonders einfach, da sie nur auf das erste Signal ausgelegt werden müssen, das als Trägersignal für das zweite Signal dient.

Hierzu wird gemäß einer weiteren vorteilhaften Ausgestaltung der Erfindung vorgeschlagen, daß ein mit dem zweiten Signal beaufschlagter Schalter an den Modulator angeschlossen ist, dem das erste Signal zuführbar ist, wobei auf Betätigung des Schalters das erste Signal im Takt des zweiten Signals abwechselnd der zweiten Sendeeinrichtung zugeleitet beziehungsweise zur Masse abgeleitet wird. Hierdurch wird eine hundertprozentige Amplitudenmodulation des ersten Signals erreicht; dieser hohe Modulationsgrad erhöht weiterhin die Störsicherheit der erfindungsgemäßen Vorrichtung.

Bei einer weiteren besonders vorteilhaften Ausführungsform der Erfindung wird der Signalerzeugungseinrichtung, die bei einigen der voranstehenden Ausführungsformen ein Oszillator ist, ein Digitalglied zur Erzeugung eines Kennwortes nachgeschaltet. Dieses Kennwort, gegebenenfalls durch weitere Informationen ergänzt, bildet das zweite Signal.

Das Kennwort kann zur Identifizierung eines bestimmten Echokopfes genutzt werden, dessen Kennwort sich von dem anderer Echoköpfe unterscheidet. Wird beispielsweise das Grundgerät an einer bestimmten Position eines Regalsystems angeordnet, so kann erreicht werden, daß nur bei genügender Annäherung eines bestimmten Echokopfes, dessen Kennwort mit dem des Grundgeräts übereinstimmt, eine Freigabe erfolgt, die Position aber für andere Echoköpfe mit anderen Kennwörtern gesperrt bleibt.

Bei einer vorteilhaften Ausgestaltung dieser Ausführungsform der Erfindung ist das Digitalglied ein Schieberegister. Das Kennwort wird im Schieberegister gespeichert und im Takt des ersten Signals ausgegeben, also "durchgeschoben".

Gemäß einer weiteren vorteilhaften Ausgestaltung der Erfindung weist das Digitalglied kodierbare Eingänge auf; dadurch läßt sich die individuelle Einstellung des Kennworts für ansonsten identische Echoköpfe besonders einfach durchführen. Zu diesem Zweck können beispielsweise Kodierstecker, Kodierschalter oder löt-oder steckbare Drahtbrücken dienen.

Auch die Modulation des ersten Signales durch das zweite Signal kann gemäß einer weiteren vorteilhaften Ausgestaltung der Erfindung besonders einfach gestaltet werden, wenn nämlich ein Ausgangssignal des Digitalgliedes auf einen Eingang eines Modulators gebbar ist, der einen weiteren Eingang aufweist, auf den das erste Signal gebbar ist. Die Vereinfachung wird besonders deutlich, wenn gemäß einer weiteren vorteilhaften Ausgestaltung der Erfindung der Modulator ein logisches ODER-Glied ist. Dieses schaltet nämlich immer dann auf den Ausgang durch, wenn mindestens ein Eingangssignal anliegt.

Gemäß einer weiteren vorteilhaften Ausgestaltung der Erfindung ist an zumindest einen der kodierbaren Eingänge des Digitalgliedes ein externer Schalter angeschlossen. Die verbleibenden Eingänge dienen dann der Einstellung des Kennworts, und durch den zusätzlichen Schalter wird eine zusätzliche Freigabebedingung geschaffen.

Bezüglich des Verfahrens zum Betrieb eines Signalgebers zur Abgabe eines Signals bei Annäherung eines zweiten Teiles an einen ersten Teil wird die Aufgabe durch folgende Schritte gelöst: Erzeugen eines Grundsignals im ersten Teil; Aussenden des Grundsignals; Empfangen des Grundsignals im zweiten Teil; Erzeugen eines ersten Signals und eines zweiten Signals in Reaktion auf den Empfang des Grundsignals; Aufprägen des zweiten Signals auf das erste Signal; Aussenden des ersten Signals; Empfangen des ersten Signals im ersten Teil des Signalgebers; Abgeben eines ersten Ausgangssignals in Reaktion auf den Empfang des ersten Signals und Abgeben eines zweiten Ausgangssignals in Reaktion auf den Empfang des zweiten Signals.

Die bezüglich der erfindungsgemäßen Vorrichtung bereits genannten Vorteile gelten sinngemäß auch für das erfindungsgemäße Verfahren, so daß zur Vermeidung von Wiederholungen auf die voranstehenden Ausführungen Bezug genommen wird. Es ist jedoch noch hervorzuheben, daß das erfindungsgemäße Verfahren nicht auf bestimmte Signale beschränkt, sondern universell an unterschiedlichste Bedingungen anpaßbar ist.

Gemäß einer vorteilhaften Ausgestaltung des erfindungsgemäßen Verfahrens durchläuft das erste Signal nach Empfang ein aktives, auf die Frequenz des ersten Signals abgestimmtes Filter. Derartige aktive Filter können besonders schmalbandig und damit störstrahlsicher ausgelegt, aber auch an unterschiedlichste Einsatzbedingungen angepaßt werden.

Bei einer weiteren vorteilhaften Ausgestaltung der Erfindung wird das zweite Signal demoduliert. Auf diese Weise ist eine einfache Abtrennung des aufgeprägten zweiten Signals vom ersten Signal möglich.

Wird gemäß einer weiteren vorteilhaften Ausgestaltung der Erfindung das Grundsignal als Grundfrequenz eines Schwingkreises erzeugt und induktiv ausgesendet, und findet der Empfang ebenfalls induktiv statt, so wird eine bedeutende Verbesserung gegenüber stationären Verfahren, die beispielsweise unter Verwendung von Permanentmagneten oder Ferriten arbeiten, erzielt.

4

Gemäß einer weiteren vorteilhaften Ausgestaltung des erfindungsgemäßen Verfahrens wird das empfangene Grundsignal gleichgerichtet, und das gleichgerichtete Signal betätigt einen Oszillator. Bei genügender Intensität des empfangenen Signals reicht das gleichgerichtete Signal aus, um den Betrieb des Oszillators zu gewährleisten.

Gemäß einer weiteren vorteilhaften Ausgestaltung der Erfindung wird die von dem Oszillator erzeugte Schwingung in einem Frequenzteiler mit einem ersten Teilerverhältnis auf die Frequenz des ersten Signals und mit einem zweiten Teilerverhältnis auf die Frequenz des zweiten Signals heruntergeteilt. Die von dem Oszillator bereitgestellte Frequenzstabilität bleibt also erhalten, so daß das erste Signal und das zweite Signal im Rahmen der Oszillatorfrequenz stabil sind.

Bei einer weiteren vorteilhaften Ausgestaltung der Erfindung beträgt die Grundfrequenz 4,5 kHz. Dies ist besonders in Ansehung der gemäß einer weiteren vorteilhaften Ausgestaltung der Erfindung bevorzugten übrigen Frequenzen von Vorteil, bei welcher der Oszillator im passiven Teil mit 655,36 kHz schwingt, und der Frequenzteiler ein erstes Signal von 40,96 kHz und ein zweites Signal von 640 Hz abgibt. Sämtliche Signale liegen daher in ihrer Frequenz soweit auseinander, daß eine gegenseitige Beeinflussung, selbst wenn man Oberwellen in Betracht zieht, vermieden wird oder vernachlässigbar ist.

Bei einer weiteren vorteilhaften Ausgestaltung des erfindungsgemäßen Verfahrens ist das zweite Signal ein digitales Kennwort. Dieses kann einstellbar oder zumindest teilweise über einen externen Schalter einstellbar sein. Die hierdurch erzielbaren Vorteile sind bereits voranstehend geschildert; sämtliche Möglichkeiten der Digitaltechnik stehen derart der Erfindung zur Verfügung.

Die Erfindung wird nachstehend anhand zeichnerisch dargestellter Ausführungsbeispiele näher erläutert, aus welchen weitere Vorteile und Merkmale hervorgehen.

Es zeigen:

Figur 1: Ein Blockschaltbild einer Ausführungsform eines erfindungsgemäßen induktiven Signalgebers;

Figur 2: ein detailliertes Schaltbild einiger Komponenten des Blockschaltbilds gemäß Figur 1; und

Figur 3: ein Blockschaltbild einer weiteren vorteilhaften Ausgestaltung der Erfindung mit einem digitalen Kennwort.

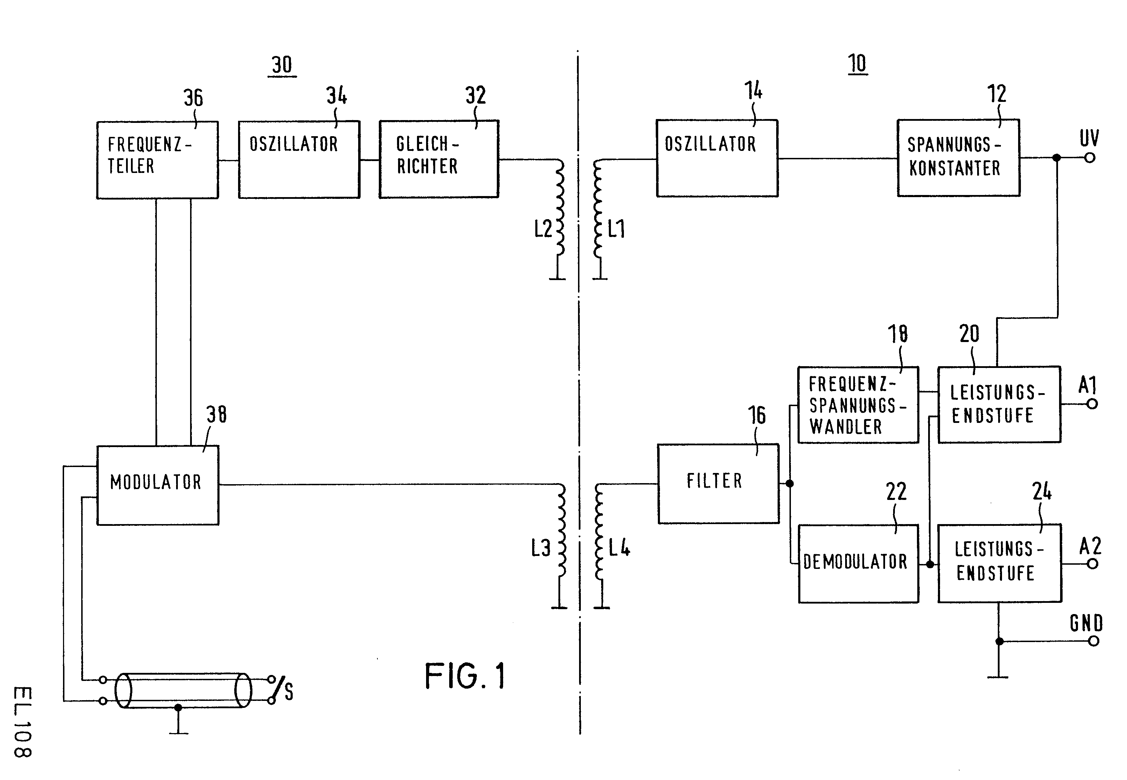

In Figur 1 sind ein erster Teil 10, das sogenannte aktive Grundgerät, und ein zweiter Teil 30, der sogenannte Echo kopf, eines erfindungsgemäßen Signalgebers dargestellt. Beide sind durch die strichpunktierte Linie in der Mitte der Figur 1 getrennt. Der aktive erste Teil 10 weist einen Eingangsanschluß UV für eine Versorgungsspannung auf, welche einem Spannungskonstanter 12 zugeleitet wird. Dieser Spannungskonstanter gibt innerhalb gewisser Schwankungen der Versorgungsspannung UV eine konstante Spannung an einen Oszillator 14 ab. Der Oszillator 14 bildet mit einer Sendespule L1 einen Schwingkreis. Der Schwingkreis aus Oszillator 14 und Spule L1 wird bei der Grundfrequenz fG betrieben, die vorteilhafterweise 4,5 kHz beträgt. Der passive Echokopf 30 weist am Eingang eine Empfangsspule L2 auf, die an einen Gleichrichter 32 angeschlossen ist, in dem das empfangene Signal mit der Grundfrequenz fG gleichgerichtet wird. Der Gleichrichter 32 gibt ein Gleichspannungssignal an einen Oszillator 34 und einen Frequenzteiler 36 ab. Wird der Oszillator 34 beispielsweise in CMOS-Bauteilen realisiert, so muß die vom Gleichrichter 32 abgegebene Gleichspannung etwa 3,5 Volt, nämlich die Schwellenspannung der CMOS-Bauteile, überschreiten, bis der Oszillator 34 arbeitet. In größerem Abstand der Spulen L1 und L2 voneinander ist die empfangene Signalintensität zu gering, als daß diese Schwellenspannung erreicht wird, so daß der Oszillator 34 auch noch nicht anschwingt. Erst bei relativ kurzem Abstand der Spulen L1 und L2 voneinander steigt die.Signalintensität auf einen derartigen Wert, daß die Schwellenspannung überschritten wird.

Das vom Oszillator 34 mit einer Frequenz von vorteilhafterweise 655,36 kHz abgegebene Signal wird auf den Frequenzteiler 36 gegeben. Hier wird die Eingangsfrequenz zur Erzeugung des ersten und des zweiten Signals heruntergeteilt. Vorteilhafterweise ist das erste Teilerverhältnis 1:1024, so daß eine Frequenz f2 von 640 Hz abgegeben wird (zweites Signal); und das andere Teilerverhältnis 1:16 zur Erzeugung der Frequenz f1 von 40,96 kHz.

Das zweite Signal wird vom Frequenzteiler 36 auf einen Schalter S gegeben. Das erste Signal mit der höheren Frequenz gelangt vom Frequenzteiler auf eine Sendespule L3 des (passiven) zweiten Teiles.

Wird der Schalter S geschlossen, so gelangt das vom Frequenzteiler 36 gelieferte zweite - (niedrigfrequente) Signal auf den Modulator und moduliert dort das erste Signal. Bei geschlossenem Schalter S liegt daher an der Sendespule L3 ein Signal an, das die Frequenz des ersten Signales hat und darüber hinaus mit der Frequenz des zweiten Signales moduliert ist.

5

Das erste Signal, gegebenenfalls durch das zweite Signal moduliert, gelangt durch induktive Kopplung bei genügender Annäherung des zweiten Teiles 30 an den ersten Teil 10 auf eine Empfangsspule L4 des ersten Teiles 10. Von der Spule L4 wird das empfangene Signal einem Filter 16 zugeleitet, das auf die Frequenz f1 des ersten Signales abgestimmt ist und andere Frequenzen ausfiltert.

Am Ausgang des Filters 16 verzweigt sich der Signalweg in zwei Pfade. Einmal wird das Signal mit der Frequenz f1 einem Frequenz-/Spannungswandler 18 zugeleitet, der die Frequenz f1 in eine proportionale Spannung umwandelt. Diese wird in einer nachgeschalteten Leistungsendstufe 20 verstärkt und auf einen Ausgang A1 gegeben. Liegt daher an diesem Augang A1 ein Signal, so bedeutet dies, daß der Echokopf 30 genügend nahe am Grundgerät 10 ist, und zwar so nahe, daß sowohl der Empfang des Grundsignals fG von genügender Intensität ist, so daß das vom Gleichrichter 32 abgegebene Gleichspannungssignal oberhalb der Schwellenspannung des Oszillators 34 liegt, als auch so nahe, daß das erste Signal über die Sendespule L3 auf die Empfangsspule L4 gelangt ist. Ist der Schalter S geschlossen und daher das erste Signal mit dem zweiten Signal im Modulator 38 moduliert, so wird das zweite Signal als Modulation des ersten Signales über die Spulen L3, L4 auf das Filter 16 gegeben und steht ebenso an dessen Ausgang bereit. Das zweite Signal wird in einem Demodulator 22 demoduliert und in einer Leistungsendstufe 24 verstärkt, die einen Ausgang A2 aufweist. Liegt daher am Ausgang A2 ein Signal an, so bedeutet dies, daß der Schalter S geschlossen und damit die zweite Bedingung erfüllt ist. Das gleichzeitige Anliegen von Signalen an den Ausgängen A1 und A2, was gegebenenfalls durch bekannte logische Schaltungen überprüft werden kann, signalisiert demzufolge die endgültige Freigabe.

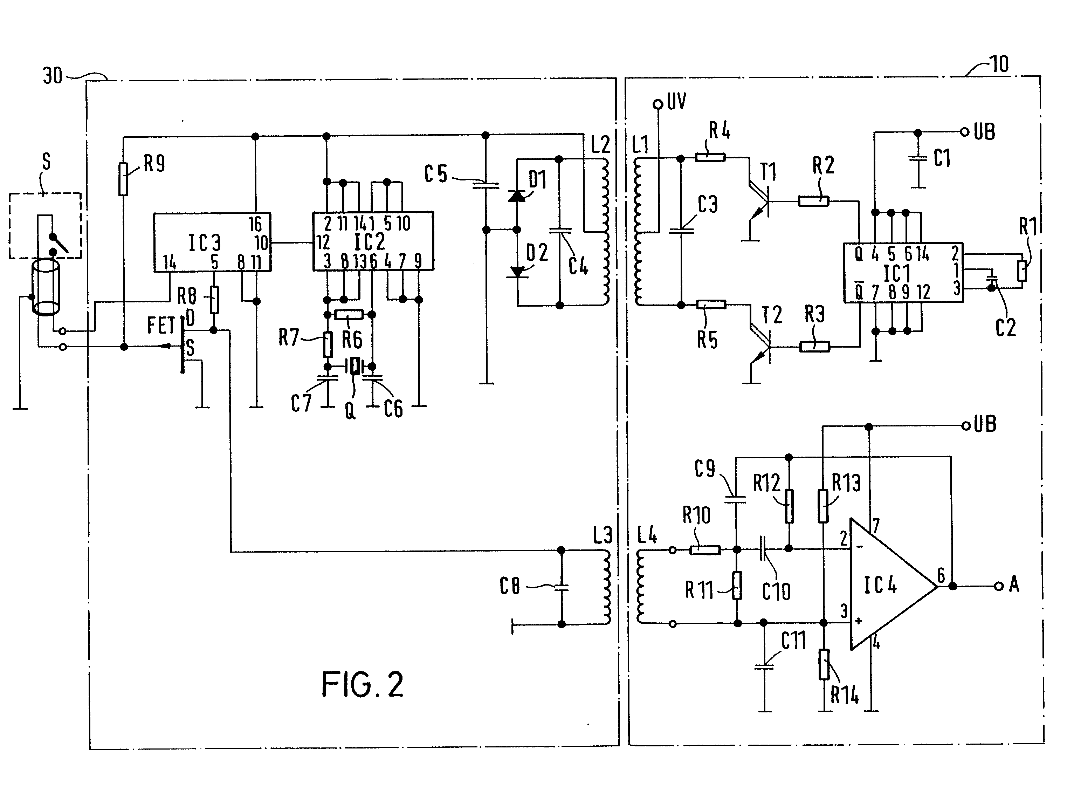

In Figur 2 sind die wesentlichen Bauteile des Blockschaltbildes von Figur 1 genauer dargestellt; zur Vereinfachung wurden die an sich bekannten Schaltungen wie Frequenz-/-Spannungswandler 18, Demodulator 22 und die Leistungsendstufen 20 und 24 sowie der Spannungskonstanter 12 weggelassen.

IC1 ist ein sogenannter Taktgeber, dessen Taktfrequenz über die Bauteile R1 an den Eingängen 2,3 beziehungsweise C2 an den Eingängen 1,3 bestimmt wird. Die Versorgungsspannung des IC1 wird von einem Eingangsanschluß UB geliefert. Der IC1 gibt an seinen Ausgängen Q, Q über Widerstände R2, R3 ein getaktetes Signal an schnelle elektronische Schalter, beispielsweise Transistoren T1, T2. Wiederum über Widerstände R4, R5 wird ein Schwingkreis mit einem Kondensator C3 und einer Spule L1 beaufschlagt. Vorzugsweise beträgt die Frequenz des von dem IC1 abgegebenen Signals 4,5 kHz, und mit dieser Frequenz schwingt daher der Schwingkreis C3, L1.

Das von der Spule L1 ausgesandte elektromagnetische Signal mit der Frequenz fG von 4,5 kHz gelangt über induktive Kopplung auf eine Empfangsspule L2 im (passiven) Echokopf 30. Die Spule L2 bildet mit einem Kondensator C4 einen Empfängerschwingkreis aus, und das empfangene Signal wird mittels Dioden D1, D2 gleichgerichtet und über einen Kondensator C5 weiter geglättet. Von dem Kondensator C5 gelangt daher ein Gleichspannungssignal an die Eingangsanschlüsse 2,11,14 einer integrierten Schaltung IC2, die das aktive Glied des in Figur 1 mit 34 bezeichneten Oszillators darstellt. Die Frequenz des Oszillators wird durch einen Quarz Q bestimmt, welcher über Widerstände R6, R7 an geeignete Eingänge 3,6 des IC2 geschaltet ist.

Der Quarz weist eine Nennfrequenz von 655,36 kHz auf, und wenn die von dem Kondensator C5 abgegebene Gleichspannung genügend groß ist, daß der IC2 überhaupt arbeiten kann, also seine Schwellenspannung überschritten ist, was bei CMOS-Ausführung eine Spannung von etwa 3,5 Volt bedeutet, so liegt an einem Ausgang 12 des IC2 ein Signal mit der durch den Quarz Q bestimmten Frequenz 655,36 kHZ an.

Dieses Oszillatorsignal wird vom Ausgang 12 des IC2 auf einen Eingang 10 eines IC3 gegeben, der als Frequenzteiler arbeitet. An einem Ausgang 5 des IC3 liegt ein um einen Faktor 16 heruntergeteiltes Signal an, welches also eine Frequenz von 40,96 kHz aufweist und das erste Signal darstellt. Dieses erste Signal gelangt über einen Widerstand R8 auf einen Ausgangsschwingkreis C8, L3 des passiven zweiten Teiles 30. Ein weiterer Ausgang 14 des Frequenzteilers IC 3 stellt ein um einen Faktor 1024 herunter geteiltes Signal, dessen Frequenz also 640 Hz beträgt, zur Verfügung, und dieses niedrigfrequente Signal ist das gewünschte zweite Signal. Dieses zweite Signal wird zu einer Schaltvorrichtung S geleitet, welche nur schematisch dargestellt ist, und gelangt bei geschlossenem Schalter S zu einem Modulator, in diesem Falle einem FET. Der Drain-Anschluß des FET ist mit dem Widerstand R8 verbunden, an dem das erste Signal liegt. Bei geschlossenem Schalter S erfolgt im Takt des zweiten, von dem Ausgang 14 des IC3 abgegebenen Signales eine Modulation des FET, dessen Source-Anschluß S das am Widerstand R8 anliegende erste Signal an den Masseanschluß leitet. Das erste Signal ist auf diese Weise durch das zweite Signal hundertprozentig amplitudenmoduliert.

Bei geschlossenem Schalter S sendet daher die Spule L3 ein Signal mit der Frequenz des ersten Signales (40,96 kHz) aus, das mit 640 Hz amplitudenmoduliert ist. Bei genügender Nähe des zweiten Teiles 30 zum ersten Teil 10 wird das von der Spule L3 ausgesandte Signal von einer Empfangsspule L4 des ersten Teiles empfangen. An die Empfangsspule L4 ist ein aktives Filter angeschlossen (Bezugsziffer 16 in Figur 1), dessen aktives Glied eine integrierte Schaltung IC4 (Operationsverstärker) ist. Durch geeignete Widerstände R10, R11, R12, R14 sowie Kapazitäten C9, C10, C11 wird die Mittenfrequenz des aktiven Bandpaßfilters auf etwa 41 kHz, die Frequenz des ersten Signales, gelegt. Der IC4 wird über einen Anschluß UB mit Betriebsspannung versorgt. An einen Ausgang 6 des Operationsverstärkers IC4 ist ein Ausgangsanschluß A angeschlossen. Dieser Ausgangsanschluß A führt einerseits zu dem Spannungs-/Frequenz-/Wandler 18 und andererseits zu dem Demodulator 22 von Figur 1.

Bei einer besonders vorteilhaften Ausführung des erfindungsgemäßen Signalgebers wurden Bauteile mit folgenden Werten beziehungseise folgende Parameter verwendet:

| | | | | |
|------|------|----------|----|-----------|
| UB | ca. 8V | | UV | 10 - 30V |
| R 1 | 4k7 | (4,7 k$\Omega$) | | |
| 2 | 4k7 | | | |
| 3 | 4k7 | | | |
| 4 | 270 | | | |
| 5 | 270 | | | |
| 6 | 10M | | | |
| 7 | 2k2 | | | |
| 8 | 4k7 | | | |
| 9 | 270k | | | |
| 10 | 27k | | | |
| 11 | 28,2 | | | |
| 12 | 1,123M | | | |
| 13 | 4k7 | | | |
| 14 | 4k7 | | | |
| C 1 | 4,7µF | | | |
| 2 | 10n | | | |
| 3 | 16,8n | | | |
| 4 | 22n | | | |
| 5 | 1µ | | | |
| 6 | 33p | | | |
| 7 | 47p | | | |
| 8 | 820p | | | |
| 9 | 680p | | | |
| 10 | 680p | | | |
| 11 | 1µ | | | |

| | |
|---|---|
| IC1 | 4047 |
| IC2 | 4007 |
| IC3 | 4040 |
| IC4 | 5534 |
| | |
| T1 | MPS A13 |
| T2 | MPS A13 |
| | |
| FET | E 175 (E 176) |
| | |
| L1 | 700 Wdg. 0,1 mm Ø |
| L2 | - " - |
| L3 | 600 Wdg. 0,1 mm Ø |
| L4 | - " - |

Selbstverständlich ist die erfindungsgemäße Lehre auch mit anderen Bauteilen und/oder Bauteilkombinationen realisierbar.

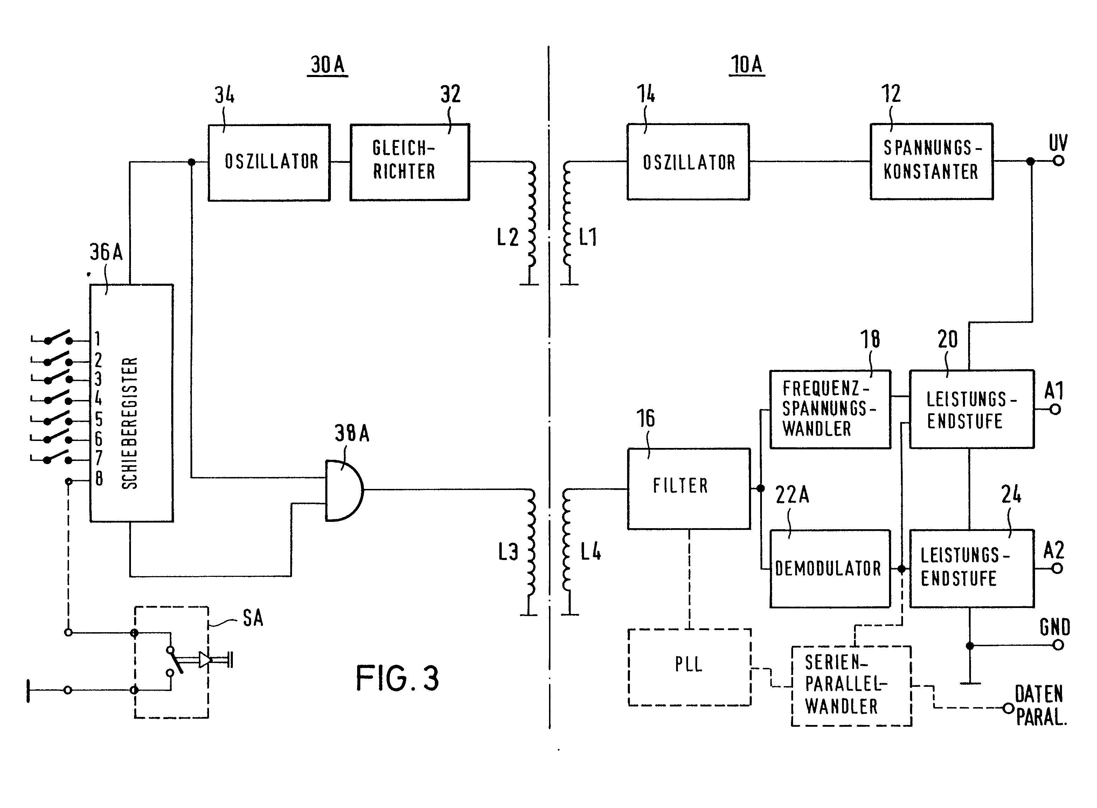

Die in Figur 3 dargestellte Ausführungsform der Erfindung weist zahlreiche Komponenten auf, die bereits im Zusammenhang mit der Ausführungsform gemäß Figur 1 beschrieben wurden und daher in Figur 3 mit denselben Bezugzeichen gekennzeichnet sind. Die Erzeugung des Grundsignals fG über einen Spannungskonstanter 12, Oszillator 14 und Spule L1 in einem Grundgerät 10A sowie der Empfang dieses Signals in einem Echokopf 30A über Spule L2, Gleichrichter 32 und Oszillator 34 wurde bereits voranstehend geschildert.

Bei der in Figur 3 dargestellten Ausführungsform ist jedoch der Ausgang des Oszillators 34 mit einem Eingang eines ODER-Gatters 38A verbunden, an dem also das vom Oszillator abgegebene Signal f1 anliegt. Dieses Signal kann auch, etwa durch einen Frequenzteiler wie den in Figur 1 mit der Bezugsziffer 36 bezeichneten, noch einmal heruntergeteilt sein (nicht in Figur 3 dargestellt).

Das Ausgangssignal des Oszillators 34 wird weiterhin auf den Eingang eines Schieberegisters 36A gegeben. Das Schieberegister weist in der in Figur 3 dargestellten Ausführung acht einstellbare Eingänge 1 bis 8 auf, ist also in 8 Bit-Ausführung ausgeführt. Selbstverständlich können aber beispielsweise in 16 Bit-Ausführung auch 16 einstellbare Eingänge vorgesehen werden oder noch mehr, falls sich dies als erforderlich erweisen sollte. Die Eingänge 1 bis 7 des Schieberegisters 36A sind über Kodierschalter, die nur schematisch dargestellt sind, einstellbar. Der letzte einstellbare Eingang 8 des Schieberegisters 36A ist an einen externen Schalter SA angeschlossen. Mit den 8 Bit sind prinzipiell 256 verschiedene digitale Datenwörter an den einstellbaren Eingängen einstellbar, bei einer 16 Bit-Ausführung entsprechend mehr. Bei der in Figur 3 dargestellten Ausführungsform können $2^7$ (128) unterschiedliche digitale Kennwörter eingestellt werden, die zur Unterscheidung ansonsten identischer Echoköpfe dienen. Das letzte Bit 8 dient dazu, über den externen Schalter eine zusätzliche Kontrollfunktion bereitzustellen.

Das mittels der Kodierschalter an den Eingängen 1 bis 7 beziehungsweise mittels des externen Schalters am Eingang 8 des Schieberegisters 36A eingestellte digitale Kennwort ist im Schieberegister 36A gespeichert und wird im Takt der von dem Oszillator 34 abgegebenen Frequenz, die ja am Eingang des Schieberegisters 36A anliegt, "durchgeschoben" und auf den Ausgang des Schieberegisters 36A gegeben. Von dort aus gelangt das digitale Kennwort auf einen zweiten Eingang des ODER-Gatters 38A. Das erste Signal f1 wird daher im ODER-Gatter 38A mit dem durch die Bits 1 bis 8 des Schieberegisters 36A vorgegebenen digitalen Kennwort moduliert. Statt des ODER-Gatters 38A kann natürlich auch eine andere geeignete Modulationseinrichtung Verwendung finden.

Der Empfangsteil des Grundgerätes 10A weist im Zusammenhang mit Figur 1 bereits eingehend beschriebene Komponenten auf, so Filter 16, Frequenz-Spannungswandler 18 und Leistungsendstufen 20, 24. Ein Demodulator 22A ist technisch etwas anders aufgebaut als der Demodulator 22, jedoch im Prinzip gleich.

Liegt daher am Ausgang A1 der Leistungsendstufe 20 ein Signal an, so bedeutet dieses, daß der Echokopf 30A genügend nahe am Grundgerät 10A ist, so daß dieses das Signal f1 empfangen kann. Das am Schieberegister 36A eingestellte digitale Kennwort (Bits 1 bis 8) liegt in serieller Form am Ausgangsanschluß A2 der Leistungsendstufe 24 an und kann gegebenenfalls durch geeignete Vergleichsschaltungen mit am Grundgerät einstellbaren Daten verglichen werden. Stimmt das digitale Kennwort des Echokopfes nicht mit dem vorgebbaren Wort des Grundgeräts 10A überein, so wird keine Freigabe erteilt.

Bei der in Figur 3 dargestellten Kodierung der Eingänge 1 bis 7 wird so erreicht, daß 128 verschiedene Echoköpfe, von denen jeder noch zusätzlich zur Freigabe die eingeschaltete Stellung des externen Schalters SA (Bit 8) benötigt, unterschieden werden können.

Gestrichelt sind in der unteren Hälfte der Figur 3 Komponenten des Grundgerätes 10A gezeigt, welche weitere Vorteile bieten. So kann an das Filter 16 eine "phased lock loop" Schaltung PLL angeschlossen sein, welche die Synchronisierung des Takts im Empfangsteil sicherstellt. Ist die Ausgabe des digitalen Kennworts nicht nur (seriell) am Ausgang A2 erwünscht, sondern auch noch parallel, so kann ein an die PLL-Schaltung und den Demodulator 22A angeschlossener Serien-Parallelwandler vorgesehen werden, dessen Ausgangsanschluß das digitale Kennwort in paralleler Form bereitstellt.

Selbstverständlich ist die erfindungsgemäße Lehre nicht nur mit den in den Figuren dargestellten, sondern auch mit anderen Bauteilen und/oder Bauteilkombinationen realisierbar.

Es wird weiterhin darauf hingewiesen, daß sowohl der erfindungsgemäße Signalgeber als auch das erfindungsgemäße Verfahren prinzipiell nicht nur, wie in den Ausführungsbeispielen dargestellt, mit elektrotechnischen Mitteln realisiert werden können, sondern beispielsweise auch mit optoelektronischen Bauelementen. Hierzu wäre es aber erforderlich, den "passiven" Teil 30, 30A nunmehr "aktiv" auszugestalten, wenn dort optoelektronische Bauelemente vorgesehen werden sollen, da diese eine eigene Stromversorgung benötigen.

**Ansprüche**

1. Berührungsloser Signalgeber zur Abgabe eines Signals bei genügender Annäherung eines zweiten Teils an einen ersten Teil,
**dadurch gekennzeichnet,**
daß der erste Teil (10, 10A) eine erste Sendeeinrichtung (14, L1) für ein Grundsignal (fG) und eine zweite Empfangseinrichtung (L4) zum Empfang eines ersten Signals (f1) aufweist, daß der zweite Teil (30, 30A) zum Empfang des Grundsignals (fG) mit einer ersten Empfangseinrichtung (L2) versehen ist, von der in Reaktion auf das Grundsignal (fG) eine Signalerzeugungseinrichtung (34, 36, 36A) zur Erzeugung des ersten Signals (f1) und eines zweiten Signals (f2), welches dem ersten Signal (f1) aufprägbar (38) ist, beaufschlagbar ist, und daß der Signalerzeugungseinrichtung (34, 36, 36A) eine zweite Sendeeinrichtung (L3) nachgeschaltet ist, deren Signal (f1) von der zweiten Empfangseinrichtung (L4) im ersten Teil (10, 10A) aufnehmbar ist.

2. Signalgeber nach Anspruch 1,
**dadurch gekennzeichnet,**
daß der zweiten Empfangseinrichtung (L4) eine Filtereinrichtung (16) nachgeschaltet ist, die auf das erste Signal (f1) abgestimmt ist.

3. Signalgeber nach Anspruch 2,
**dadurch gekennzeichnet,**
daß der Filtereinrichtung (16) weiterhin eine auf das zweite Signal (f2) abgestimmte Einrichtung (22, 22A) nachgeschaltet ist.

4. Signalgeber nach Anspruch 2 oder 3,
**dadurch gekennzeichnet,**
daß die Filtereinrichtung ein aktives Bandpaßfilter (16) ist.

5. Signalgeber nach Anspruch 2, 3 oder 4,
**dadurch gekennzeichnet,**
daß der Filtereinrichtung (16) eine erste Einrichtung (18, 20) zur Erzeugung eines ersten Ausgangssignals - (A1) in Reaktion auf das erste Signal (f1) nachgeschaltet ist.

6. Signalgeber nach Anspruch 3, 4 oder 5,
**dadurch gekennzeichnet ,**
daß der auf das zweite Signal (f2) abgestimmten Einrichtung (22, 22A) eine Einrichtung (24) zur Erzeugung eines zweiten Ausgangssignals (A2) nachgeschaltet ist.

7. Signalgeber nach Anspruch 1 oder einem der folgenden Ansprüche,
**dadurch gekennzeichnet,**
daß die erste Sendeeinrichtung eine Induktivität (L1) und daran gekoppelten Oszillator (14) aufweist und daß die erste Empfangseinrichtung eine Induktivität (L2) ist.

8. Signalgeber nach Anspruch 7,
**dadurch gekennzeichnet,**
daß das Grundsignal (fG) eine Frequenz von etwa 4,5 kHz hat.

9. Signalgeber nach Anspruch 7 oder 8,
**dadurch gekennzeichnet,**
daß an die erste Empfangseinrichtung (L2) ein Gleichrichter (32) angeschlossen ist.

10. Signalgeber nach Anspruch 9,
**dadurch gekennzeichnet,**
daß der Gleichrichter (32) die Signalerzeugungseinrichtung (34, 36, 36A) mit einem Gleichspannungssignal beaufschlagt.

11. Signalgeber nach Anspruch 10,
**dadurch gekennzeichnet,**
daß die Signalerzeugungseinrichtung (34, 36, 36A) einen Oszillator (34) mit einem frequenzbestimmenden Glied (Q) umfaßt.

12. Signalgeber nach Anspruch 11,
**dadurch gekennzeichnet,**
daß das frequenzbestimmende Glied ein Schwingquarz (Q) ist.

13. Signalgeber nach Anspruch 11 oder 12,
**dadurch gekennzeichnet,**
daß dem Oszillator (34) ein Frequenzteiler (36) nachgeschaltet ist.

14. Signalgeber nach Anspruch 13,
**dadurch gekennzeichnet,**
daß von dem Frequenzteiler (36) das erste Signal (f1) und das zweite Signal (f2) abgebbar ist.

15. Signalgeber nach Anspruch 1 oder einem der fogenden Ansprüche,
**dadurch gekennzeichnet,**
daß das erste Signal (f1) eine Frequenz von etwa 41 kHz aufweist.

16. Signalgeber nach Anspruch 1 oder einem der folgenden Ansprüche,
**dadurch gekennzeichnet,**
daß das zweite Signal (f2) eine Frequenz von etwa 600 bis 700 Hz aufweist.

17. Signalgeber nach Anspruch 14, 15 oder 16,
**dadurch gekennzeichnet,**
daß der Schwingquarz eine Schwingfrequenz von 655,36 kHz aufweist, die von dem Frequenzteiler auf 40,96 kHz zur Erzeugung des ersten Signals (f2) heruntergeteilt wird.

18. Signalgeber nach Anspruch 1 oder einem der folgenden Ansprüche,
**dadurch gekennzeichnet,**
daß zur Aufprägung des zweiten Signals (f2) auf das erste Signal (f1) ein Modulator (38, 38A) vorgesehen ist.

19. Signalgeber nach Anspruch 18,
**dadurch gekennzeichnet,**
daß ein mit dem zweiten Signal (f2) beaufschlagter Schalter (5) an den Modulator (38) angeschlossen ist, dem das erste Signal (f1) zuführbar ist, wobei auf Betätigung des Schalters (5) das erste Signal (f1) im Takt des zweiten Signals (f2) abwechselnd der zweiten Sendeeinrichtung (L3) zugeführt beziehungsweise zur Masse abgeleitet wird.

20. Signalgeber nach einem der Ansprüche 1 bis 13, 15, 17 oder 18,
**dadurch gekennzeichnet,**
daß der Signalerzeugungseinrichtung (34) ein Digitalglied (36A) zur Erzeugung eines Kennworts nachgeschaltet ist.

21. Signalgeber nach Anspruch 20,
**dadurch gekennzeichnet,**
daß das Digitalglied ein Schieberegister (36A) ist.

22. Signalgeber nach Anspruch 20 oder 21,
**dadurch gekennzeichnet,**
daß das Digitalglied (36A) kodierbare Eingänge (1 bis 8) aufweist.

23. Signalgeber nach Anspruch 20, 21 oder 22,

**dadurch gekennzeichnet ,**

daß ein Ausgangssignal des Digitalgliedes (36A) auf einen Eingang eines Modulators (38A) gebbar ist, der einen weiteren Eingang aufweist, auf den das erste Signal (f1) gebbar ist.

24. Signalgeber nach Anspruch 23,

**dadurch gekennzeichnet,**

daß der Modulator ein ODER-Glied (38A) ist.

25. Signalgeber nach einem der Ansprüche 22 bis 24,

**dadurch gekennzeichnet,**

daß an zumindest einen der kodierbaren Eingänge (1 bis 8) ein externer Schalter (SA) angeschlossen ist.

26. Verfahren zum Betrieb eines Signalgebers zur Abgabe eines Signals bei Annäherung eines zweiten Teiles an einen ersten Teil,

**gekennzeichnet durch** folgende Schritte:

-Erzeugen eines Grundsignals (fG) im ersten Teil (10, 10A);

-Aussenden des Grundsignals (fG);

-Empfangen des Grundsignals (fG) im zweiten Teil (30, 30A);

-Erzeugen eines ersten Signals (f1) und eines zweiten Signals (f2) in Reaktion auf den Empfang des Grundsignals;

-Aufprägen des zweiten Signals (f2) auf das erste Signal (f1);

-Aussenden des ersten Signals (f1);

-Empfangen des ersten Signals (f1) im ersten Teil (10, 10A) des Signalgebers;

-Abgeben eines ersten Ausgangssignals (A1) in Reaktion auf den Empfang des ersten Signals (f1);

-Abgeben eines zweiten Ausgangssignals (A2) in Reaktion auf den Empfang des zweiten Signals (f2).

27. Verfahren nach Anspruch 26,

**dadurch gekennzeichnet,**

daß das erste Signal (f1) nach Empfang ein aktives, auf die Frequenz (f1) abgestimmtes Filter (16) durchläuft.

28. Verfahren nach Anspruch 27,

**dadurch gekennzeichnet,**

daß das zweite Signal (f2) demoduliert wird.

29. Verfahren nach Anspruch 26, 27 oder 28,

**dadurch gekennzeichnet,**

daß das Grundsignal (fG) als Grundfrequenz eines Schwingkreises (14, L1) erzeugt und induktiv (L1) ausgesendet wird, und daß der Empfang ebenfalls induktiv (L2) stattfindet.

30. Verfahren nach Anspruch 26 oder einem der folgenden Ansprüche,

**dadurch gekennzeichnet,**

daß das empfangene Signal (fG) gleichgerichtet (32) wird und das gleichgerichtete Signal einen Oszillator - (34) betätigt.

31. Verfahren nach Anspruch 30,

**dadurch gekennzeichnet,**

daß die von dem Oszillator (34) erzeugte Schwingung in einem Frequenzteiler (36) mit einem ersten Teilerverhältnis auf die Frequenz des ersten Signals (f1) und mit einem zweiten Teilerverhältnis auf die Frequenz des zweiten Signals (f2) heruntergeteilt wird.

32. Verfahren nach Anspruch 26 oder einem der folgenden Ansprüche,

**dadurch gekennzeichnet,**

daß die Grundfrequenz (fG) 4,5 kHz beträgt.

33. Verfahren nach Anspruch 30, 31 oder 32,

**dadurch gekennzeichnet,**

daß der Oszillator (34) mit 655,36 kHz schwingt und der Frequenzteiler (36) ein erstes Signal (f1) von 40,96 kHz und ein zweites Signal (f2) von 640 Hz abgibt.

34. Verfahren nach einem der Ansprüche 26 bis 29,

**dadurch gekennzeichnet,**

daß das zweite Signal (f2) ein digitales Kennwort ist.

35. Verfahren nach Anspruch 34,

**dadurch gekennzeichnet,**

daß das digitale Kennwort einstellbar und/oder änderbar ist.

36. Verfahren nach Anspruch 34 oder 35,
**dadurch gekennzeichnet,**
daß das digitale Kennwort zumindest teilweise über einen externen Schalter (SA) einstellbar ist.

FIG.1

FIG. 2

EL 108

0 229 247

FIG. 3

EL 108